# EUROPEAN PATENT APPLICATION

(11) **EP 4 707 991 A1**
(43) Date of publication of application: **11.03.2026**
(21) Application number: 25199661.7
(22) Date of filing: 02.09.2025
(51) Int. Cl.: G06F 1/16, G06F 3/0482, G06F 3/04842, G06F 3/0488

(54) **DISPLAY DEVICE AND ELECTRONIC APPARATUS INCLUDING THE SAME**

(30) Priority: 06.09.2024 JP 2024154173; 25.08.2025 JP 2025139739
(71) Applicant: KYOCERA Document Solutions Inc., Osaka-shi, Osaka 540-8585 (JP)
(72) Inventor: OKAUCHI, Yoshifumi, Osaka, 540-8585 (JP)
(74) Representative: BRP Renaud & Partner mbB Rechtsanwälte Patentanwälte Steuerberater

(57) **Abstract**

A display device (100) includes: a display module (1) that has a flat surface (1A) rectangular in shape and that displays information on a display area (DA) within the flat surface (1A); and a protective sheet (2) affixed to the flat surface (1A). An outer edge of the protective sheet (2) is positioned, as viewed from a direction orthogonal to the flat surface (1A), on an outer edge of the flat surface (1A) or inward of the outer edge of the flat surface (1A). The protective sheet (2) has a cutout (20) having been formed therein by cutting the protective sheet (2) inward from the outer edge of the protective sheet (2) as viewed from the direction orthogonal to the flat surface (1A).

## Description

### BACKGROUND

The present disclosure relates to a display device and an electronic apparatus including the same.

A protective sheet is affixed to the surface of a display device, such as a liquid crystal display panel.

For example, image forming apparatuses, which are electronic apparatuses, include an operation panel serving as a display device. The operation panel includes a display panel, which is a rectangular flat surface, and displays information on the display panel. The operation panel may also include a touch panel in addition to the display panel. The touch panel is disposed on the surface of the display panel. There is a case where a protective sheet is initially affixed to the surface of the display panel (or the surface of the touch panel).

If the protective sheet includes a tab, a user can pinch the tab when removing the protective sheet from the operation panel, which contributes to enhanced user-friendliness. However, if the protective sheet has a tab, the tab may come into contact with the user's body or an external member before the user removes the protective sheet. If that happens, part of the protective sheet around the tab may be deformed or may come off, which is inconvenient.

### SUMMARY

According to a first aspect of the present disclosure, a display device includes a display module and a protective sheet. The display module has a flat surface rectangular in shape, and displays information on a display area within the flat surface. The protective sheet is affixed to the flat surface. An outer edge of the protective sheet is positioned, as viewed from a direction orthogonal to the flat surface, on an outer edge of the flat surface or inward of the outer edge of the flat surface. The protective sheet has a cutout having been formed therein by cutting the protective sheet inward from the outer edge of the protective sheet as viewed from the direction orthogonal to the flat surface.

According to a second aspect of the present disclosure, an electronic apparatus includes the display device described above. The display device displays information related to the electronic apparatus.

### BRIEF DESCRIPTION OF THE DRAWINGS

FIG. 1 is a diagram schematically illustrating an image forming apparatus according to an embodiment.
FIG. 2 is an exploded perspective view of an operation panel according to an embodiment.
FIG. 3 is a plan view of an operation panel according to an embodiment as seen from an operation receiving direction.
FIG. 4 is a plan view of and around a cutout formed in a protective sheet according to an embodiment as seen from the operation receiving direction.
FIG. 5 is a sectional view of and around a cutout formed in the protective sheet according to an embodiment (a sectional view taken along line A-A' of FIG. 4).

### DETAILED DESCRIPTION

### <Configuration of Image Forming Apparatus>

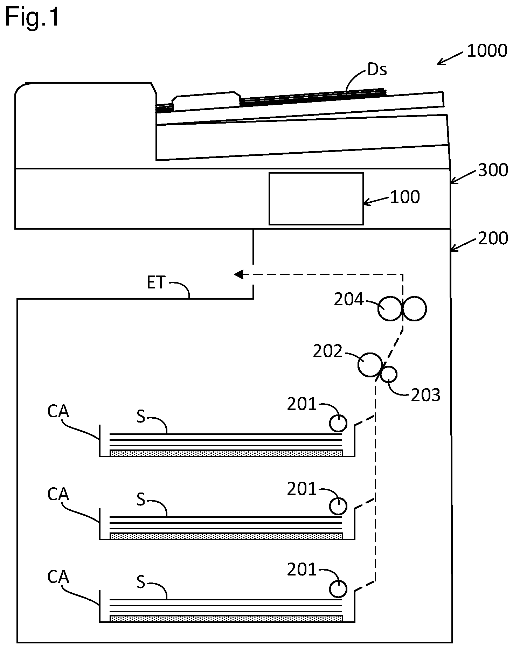

An image forming apparatus 1000 according to the present embodiment has a configuration as shown in FIG. 1. The image forming apparatus 1000 is an example of an "electronic apparatus" of the present disclosure. The image forming apparatus 1000 is capable of executing a print job for printing an image on a sheet S. For example, the image forming apparatus 1000 is a monochrome multifunction peripheral. However, this is not meant as a limitation. The image forming apparatus 1000 may be a color multifunction peripheral. Or, the image forming apparatus 1000 may be a printer. Note that the present disclosure is also applicable to other electronic apparatuses, such as communication devices and information processing devices.

The image forming apparatus 1000 includes an operation panel 100. The operation panel 100 is an example of a "display device" of the present disclosure. The operation panel 100 displays information related to the image forming apparatus 1000. Further, the operation panel 100 receives a setting operation related to the image forming apparatus 1000 from a user of the image forming apparatus 1000. For example, the operation panel 100 receives a setting related to a print job. To give an example, setting items related to a print job include items such as the size of a sheet S to be used in the print job, the density of an image to be printed on the sheet S, printing magnification, the number of sheets to be printed, the number of copies to be printed, etc. The operation panel 100 will be described later in detail.

The image forming apparatus 1000 includes a printing portion 200. The printing portion 200 constitutes the main body of the image forming apparatus 1000. For example, the printing portion 200 employs an electrophotographic method. However, this is not meant as a limitation. The printing portion 200 may employ an inkjet method.

Note that FIG. 1 schematically illustrates the inner mechanism of the printing portion 200. In practice, the inner mechanism of the printing portion 200 is covered with an exterior cover.

The printing portion 200 conveys a sheet S along a sheet conveyance path. In FIG. 1, the sheet conveyance path is indicated by a broken line. The printing portion 200 prints an image onto a conveyed sheet S.

The printing portion 200 includes a sheet feed roller 201. The sheet feed roller 201 makes contact with a sheet S stored in a sheet cassette CA, and rotates in that state. Thereby, the sheet feed roller 201 feeds the sheet S from the sheet cassette CA into the sheet conveyance path.

The printing portion 200 includes a photosensitive drum 202 and a transfer roller 203. The photosensitive drum 202 carries a toner image on its circumferential surface. The transfer roller 203 is pressed against the photosensitive drum 202, and rotates with the photosensitive drum 202. The transfer roller 203 forms a transfer nip between itself and the photosensitive drum 202. The printing portion 200, while conveying a sheet S that has entered the transfer nip, transfers a toner image onto the sheet S.

The printing portion 200 further includes a charger, an exposure device, and a developing device, of which none is illustrated. The charger charges the circumferential surface of the photosensitive drum 202. The exposure device forms an electrostatic latent image on the circumferential surface of the photosensitive drum 202. The developing device develops the electrostatic latent image on the circumferential surface of the photosensitive drum 202 into a toner image.

The printing portion 200 includes a fixing roller pair 204. The fixing roller pair 204 includes a heat roller and a pressure roller. The heat roller has a heater. The pressure roller is pressed against the heat roller, and rotates with the heat roller. The pressure roller forms a fixing nip between itself and the heat roller. The fixing roller pair 204, while conveying a sheet S that has entered the fixing nip, fixes a toner image, which has been transferred onto the sheet S, onto the sheet S. Passing through the fixing nip, the sheet S is ejected onto an ejection tray ET.

The image forming apparatus 1000 further includes an image reading portion 300. The image reading portion 300 is disposed at an upper part of the main body of the image forming apparatus 1000. In a job that includes reading of a source document Ds, the source document Ds is set on the image reading portion 300. The image reading portion 300 reads the source document Ds set on the image reading portion 300, and generates image data of the source document Ds that has been read.

Incidentally, the operation panel 100 is disposed in front of the image reading portion 300. However, this is not meant as a limitation. The operation panel 100 may be disposed in front of the main body of the image forming apparatus 1000 (i.e., the printing portion 200).

### <Configuration of Operation Panell>

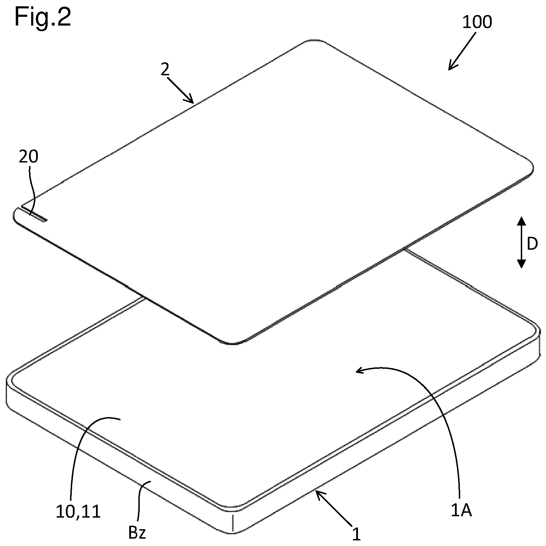

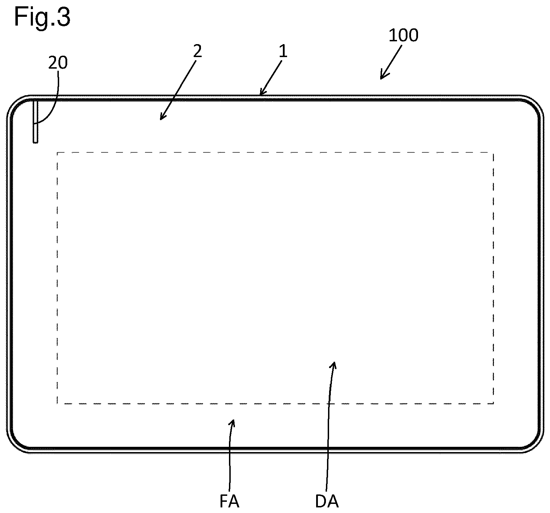

As shown in FIGS. 2 and 3, the operation panel 100 of the present embodiment includes a touch screen 1. The touch screen 1 is constituted of a display module that includes a touch panel 11. That is, the touch screen 1 is an example of a "display module" of the present disclosure. The display module may be a liquid crystal display module or may be an organic electroluminescence display module. The touch panel 11 employs a capacitive method, for example. Another example of the "display module" of the present disclosure is a display module that does not have a touch panel 11.

The display module displays various images, such as a button image. The touch panel 11 is disposed on the display surface of the display module. The touch panel 11 has light transmissivity. Consequently, even with the touch panel 11 placed on the display surface of the display module, images displayed on the display module are visible.

The touch screen 1 displays images on the display module, and receives touch operations performed by a user with respect to the touch panel 11. The user, while visually confirming the displayed images, performs a touch operation with respect to the position of a desired image (such as a button image). A touch operation may be performed with a finger of the user's hand or may be performed with a touch pen.

The touch screen 1 is connected to a control portion (not shown) including components such as a CPU and the like. The touch screen 1 outputs, to the control portion, a signal that indicates the position where the touch operation has been performed by the user. Based on this signal, the control portion detects the touch operation having been performed with respect to the touch screen 1 (i.e., the operation having been performed with respect to the operation panel 100).

Further, the touch screen 1 includes a bezel Bz. The bezel Bz constitutes the frame of the touch screen 1.

The touch screen 1 includes a transparent plate 10 that has a rectangular-plate shape. The transparent plate 10 may be a glass plate, or may be a resin plate. The transparent plate 10 is rectangular in shape as viewed from its thickness direction. However, as viewed from its thickness direction, the four corners of the transparent plate 10 are R-chamfered. The transparent plate 10, which is one component of the touch panel 11, is disposed at the uppermost layer of the touch screen 1. That is, the touch screen 1 has a rectangular flat surface (the flat surface being the surface of the transparent plate 10) as the surface of the uppermost layer.

The touch screen 1 has the surface of the transparent plate 10 as a surface 1A (hereinafter referred to as the operation receiving surface 1A) for receiving a touch operation from a user. In this configuration, the operation receiving surface 1A is a flat surface rectangular in shape as viewed from the thickness direction of the transparent plate 10. The operation receiving surface 1A is equivalent to a "flat surface" of the present disclosure. Note that the operation receiving surface 1A is the surface of the touch panel 11. That is, the transparent plate 10 is a component of the touch panel 11.

In the following description, for the sake of convenience, a direction orthogonal to the operation receiving surface 1A (i.e., the direction of the normal to the operation receiving surface 1A) will be referred to simply as an operation receiving direction. The operation receiving direction is denoted by reference sign D. The operation receiving direction D, which is the same direction as the thickness direction of the transparent plate 10, is equivalent to a "direction orthogonal to the flat surface" of the present disclosure.

Further, in the following description, an outside as viewed from the operation receiving direction D refers to a side located outward of the outer edge of the operation receiving surface 1A (that is, an area outside the operation receiving surface 1A). On the other hand, an inside as viewed from the operation receiving direction D refers to a side located inward of the outer edge of the operation receiving surface 1A (that is, an area inside the operation receiving surface 1A).

The operation panel 100 includes a protective sheet 2. The protective sheet 2 is a transparent sheet. The protective sheet 2 is affixed to the operation receiving surface 1A (i.e., the top surface of the transparent plate 10). Thereby, the protective sheet 2 protects the operation receiving surface 1A. The affixation of the protective sheet 2 to the operation receiving surface 1A helps prevent a touching object, such as a finger of the user, a touch pen, or the like, from directly contacting the operation receiving surface 1A, making it possible to suppress occurrence of inconveniences such as damage to the operation receiving surface 1A. The material of the protective sheet 2 is not particularly limited, and any known sheets (such as a PET sheet) are usable as the protective sheet 2.

The protective sheet 2 covers substantially all of the operation receiving surface 1A. However, the protective sheet 2, as viewed from the operation receiving direction D, does not protrude outward beyond the outer edge of the transparent plate 10. In other words, the protective sheet 2 is disposed inside the bezel Bz, and does not protrude outward beyond the bezel Bz.

Specifically, the protective sheet 2 is formed so as to have an area (a shape) as viewed from the operation receiving direction D that is substantially the same as the area (the shape) of the operation receiving surface 1A as viewed from the operation receiving direction D. That is, similarly to the transparent plate 10, the protective sheet 2 is rectangular in shape as viewed from the operation receiving direction D, with its four corners R-chamfered. Further, the outer edge of the protective sheet 2 is positioned on the outer edge of the transparent plate 10 as viewed from the operation receiving direction D. In this arrangement, as viewed from the operation receiving direction D, the protective sheet 2 does not protrude outward beyond the outer edge of the transparent plate 10 and substantially all of the operation receiving surface 1A is covered with the protective sheet 2.

Note that the touch screen 1 has a display area DA and a frame area FA. In other words, the operation receiving surface 1A is divided into the display area DA and the frame area FA. The display area DA, which is the central area of the operation receiving surface 1A as viewed from the operation receiving direction D, is a rectangular area. The frame area FA, which is an area surrounding the display area DA as viewed from the operation receiving direction D. In FIG. 3, the area enclosed by the broken line is the display area DA, and the area around the display area DA is the frame area FA.

The touch screen 1 displays an image in the display area DA. On the other hand, the touch screen 1 does not display any image in the frame area FA. However, the touch screen 1 receives a touch operation performed with respect to the frame area FA. That is, similarly to the display area DA, the frame area FA is an area where touch operations are performed.

For example, the frame area FA has a home-button area. The home-button area is provided with a predetermined symbol image (not shown). On receiving a touch operation performed with respect to the home-button area, the operation panel 100 changes the screen displayed on the touch screen 1 to a predetermined home screen.

In this configuration, it is necessary to protect not only the display area DA but also the frame area FA of the touch screen 1. For this reason, the protective sheet 2 is affixed to substantially all of the operation receiving surface 1A. Thereby, as viewed from the operation receiving direction D, the display area DA and the frame area FA are entirely covered with the protective sheet 2.

By covering substantially all of the operation receiving surface 1A with the protective sheet 2, it is possible to provide satisfactory protection of the operation receiving surface 1A. However, this is not meant as a limitation. The outer edge of the protective sheet 2 may be positioned inward of the outer edge of the transparent plate 10. Any arrangement is acceptable as long as the protective sheet 2 at least does not protrude outward beyond the outer edge of the transparent plate 10 as viewed from the operation receiving direction D.

Here, if part of the protective sheet 2 protrudes outward beyond the outer edge of the transparent plate 10 (in other words the outer edge of the bezel Bz), it is likely for the user's body, an external member, and the like to touch the protruding part of the protective sheet 2. If the user's body, an external member, or the like touches the protruding part of the protective sheet 2, the part around the protruding part may be deformed or may come off and lift. In that case, an air bubble becomes trapped between the protective sheet 2 and the transparent plate 10. An air bubble trapped between the protective sheet 2 and the transparent plate 10 degrades appearance quality. It also reduces adhesion between the protective sheet 2 and the transparent plate 10, potentially leading to unintended removal of the protective sheet 2 from the transparent plate 10, which is inconvenient. For example, if the protective sheet 2 is provided with a tab, the likelihood of such inconvenience increases.

On the other hand, if the protective sheet 2 does not protrude outward beyond the outer edge of the transparent plate 10, the likelihood of such inconvenience can be suppressed. Specifically, air bubbles become less likely to be trapped between the protective sheet 2 and the transparent plate 10. Further, it is possible to suppress unintended removal of the protective sheet 2 from the transparent plate 10.

### <Cutout of Protective Sheet>

When the protective sheet 2 affixed to the touch screen 1 (i.e., the transparent plate 10) becomes unnecessary, it is removed from the touch screen 1. For example, when the existing protective sheet 2 deteriorates, the deteriorated protective sheet 2 is removed and a brand-new protective sheet 2 is affixed to the touch screen 1. Some users may find the protective sheet 2 unnecessary, regardless of how deteriorated it is. In that case, as soon as the image forming apparatus 1000 is delivered to a user, the protective sheet 2 is removed from the touch screen 1.

For example, with a configuration where part of the protective sheet 2 protrudes outward beyond the outer edge of the transparent plate 10, the protruding part can function as a tab. In that configuration, by pinching the protruding part of the protective sheet 2 with fingers, the protective sheet 2 can be easily removed from the transparent plate 10.

By contrast, with the configuration where the protective sheet 2 does not protrude outward beyond the outer edge of the transparent plate 10, it is difficult to pinch the protective sheet 2 with fingers. That is, the protective sheet 2 cannot be removed easily from the transparent plate 10.

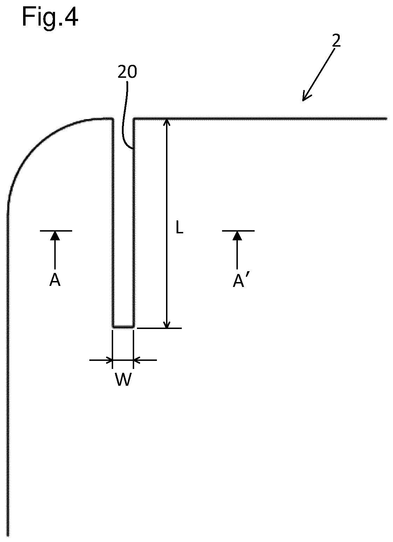

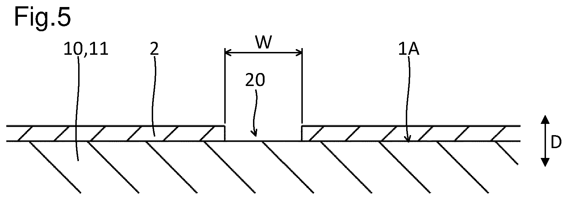

This inconvenience is addressed in the present embodiment by forming a cutout 20 in the protective sheet 2. A plan view of and around the cutout 20 is shown in FIG. 4. Further, an enlarged sectional view of and around the cutout 20 is shown in FIG. 5.

The cutout 20 extends inward from the outer edge of the protective sheet 2 as viewed from the operation receiving direction D. As viewed from the operation receiving direction D, the cutout 20 is an extremely narrow slit that extends linearly. The cutout 20 has a width W of approximately 1 mm and a length L of approximately 10 mm.

In the present embodiment, by forming the cutout 20 in the protective sheet 2, even without making part of the protective sheet 2 protrude beyond the outer edge of the transparent plate 10 to function as a tab, it is possible to facilitate removal of the protective sheet 2 from the transparent plate 10. Specifically, when removing the protective sheet 2 from the transparent plate 10, by first inserting a tool (e.g., a spatula), a fingernail, or the like between the protective sheet 2 and the transparent plate 10 through the cutout 20, part of the protective sheet 2 around the cutout 20 comes off from the transparent plate 10. After that, by pinching the part around the cutout 20 with fingers and pulling it up, the protective sheet 2 can be easily removed from the transparent plate 10.

In the present embodiment, since the protective sheet 2 is formed not to protrude outward beyond the outer edge of the transparent plate 10, it is possible to suppress deformation and removal of the protective sheet 2. That is, unintended deformation and removal of the protective sheet 2 can be suppressed without impairing the workability in removing the protective sheet 2 from the touch screen 1.

Further, according to the present embodiment, the cutout 20 is disposed in a corner part of the protective sheet 2 as viewed from the operation receiving direction D. This arrangement helps make the cutout 20 formed in the protective sheet 2 less noticeable.

Further, according to the present embodiment, the cutout 20 is disposed, as viewed from the operation receiving direction D, within a range from the outer edge of the protective sheet 2 to the border between the frame area FA and the display area DA. This arrangement helps prevent poor visibility of images displayed on the touch screen 1.

The embodiment disclosed herein is merely an example in every aspect, and should not be interpreted as a limitation. The scope of the present disclosure is defined not by the above description of the embodiment but by the claims.

## Claims

1. A display device (100), comprising:
a display module (1) that has a flat surface (1A) rectangular in shape and that displays information on a display area (DA) within the flat surface (1A); and
a protective sheet (2) affixed to the flat surface (1A),
wherein
an outer edge of the protective sheet (2) is positioned, as viewed from a direction orthogonal to the flat surface (1A), on an outer edge of the flat surface (1A) or inward of the outer edge of the flat surface (1A), and
the protective sheet (2) has a cutout (20) having been formed therein by cutting the protective sheet (2) inward from the outer edge of the protective sheet (2) as viewed from the direction orthogonal to the flat surface.

2. The display device (100) according to claim 1,
wherein
the protective sheet (2) is rectangular in shape as viewed from the direction orthogonal to the flat surface (1A), and
the cutout (20) is disposed in a corner part of the protective sheet (2) as viewed from the direction orthogonal to the flat surface (1A).

3. The display device (100) according to claim 1 or 2,
wherein
the protective sheet (2), as viewed from the direction orthogonal to the flat surface (1A), covers the display area (DA) and a frame area (FA) enclosing the display area (DA), and
the cutout (20) is disposed, as viewed from the direction orthogonal to the flat surface (1A), within a range from the outer edge of the protective sheet (2) to a border between the frame area (FA) and the display area (DA).

4. The display device (100) according to any one of claims 1 to 3,
wherein
the display module (1) includes a touch panel (11),
the touch panel (11) has an operation receiving surface (1A) that receives an operation, and
the flat surface (1A) is the operation receiving surface (1A).

5. An electronic apparatus (1000) comprising the display device (100) according to any one of claims 1 to 4,
wherein
the display device (100) displays information related to the electronic apparatus (1000).

6. An electronic apparatus (1000) comprising the display device (100) according to claim 4,
wherein
the display device (100) receives a setting operation related to the electronic apparatus (1000).
